# EUROPEAN PATENT SPECIFICATION

(11) **EP 2 487 327 B1**
(45) Date of publication and mention of the grant of the patent: **14.10.2015**
(21) Application number: 11153781.7
(22) Date of filing: 09.02.2011
(51) Int. Cl.: E21B 41/00, E21B 47/01, H05K 7/20

(54) **Subsea electronic system**
Unterwasserelektroniksystem
Système électronique sous-marin

(43) Date of publication of application: 15.08.2012
(73) Proprietor: Siemens Aktiengesellschaft, 80333 München (DE)
(72) Inventor: Boe, Ove, 7549, Tanem (NO)

(56) References cited:
- WO-A2-2011/009022
- US-A- 4 302 793
- US-A- 4 400 858
- US-A1- 2008 302 115
- US-A1- 2009 009 959
- US-A1- 2009 154 164
- US-A1- 2009 180 281
- US-A1- 2010 024 436

## Description

### Filed of the invention

The invention relates to a subsea electronic system comprising a water tight enclosure adapted to enable an operation of the system under water.

### Background of the invention

In offshore oil or gas production, drilling rigs such as drilling vessels or oil platforms are generally used. In the operation of such drilling rigs, it can be necessary to install electronics under water, e.g. for controlling functions of a subsea Christmas tree or a subsea blowout preventer. Recently, subsea wells are being established in which production equipment is relocated to the sea floor. Electronic components are required for both power supply and control. For large scale subsea processing, electronic equipment such as transformers, switchgear or variable speed drives need to be installed near the well. It has to be ensured that the installed equipment operates reliability even under the high pressures exerted by the sea water at great depths of water of e.g. more than 1000 or even 2000 meters.

Generally, there are two types of enclosures that can be used for encapsulating electronic equipment. Some electronic components are for example installed by placing the components in a canister having an internal pressure of approximately one atmosphere (close to 1 bar). For this purpose, the canisters are provided with a thick wall in order to withstand the pressure at the sea floor. This thick wall represents a high resistance to the heat losses of the electronic components located inside the canister. In addition, the thermal conductivity of the materials used is generally-relatively poor. Accordingly, in operation, heat accumulates in the canister and there is a risk that the electronic component is overheating.

Besides using the above mentioned, pressure resistant enclosures, which are capable of maintaining an inside pressure of close to one atmosphere, pressure compensated enclosures are known in which the internal pressure is approximately equal to the external pressure exerted on the enclosure when deployed under water. Such pressure compensated enclosures can be provided with thinner walls which improves the heat transfer. Yet in particular power electronic product large amounts of heat which are difficult to dissipate even in thinner walled pressure compensated enclosures. Higher operating temperatures can have adverse effects on error-free operation, maintenance intervals and lifetime of the electronic component.

WO 2011/009022 A2 discloses an apparatus of heat dissipaters for electronic components in downhole tools. The electronic components are received in a housing, and a thermally conductive flowable material is provided in the housing and is in thermal communication with the components.

US2008/0302115 A1 discloses a combined pressure compensator and cooling unit, in which a first contained comprising electronic equipment and a second container are provided. The volume of the second container can be increased to contain the increased volume of heated cooling fluid.

A possibility of improving the heat dissipation from the electronic component is to increase the size of the canister. Yet such an approach will attract higher production costs and also generally leads to an increase of the wall thickness.

### Summary

Accordingly, there is a need for enhancing the cooling of an electronic component of a subsea electronic system and to obviate at least some of the drawbacks mentioned above. This need is met by the features of the independent claims. The dependent claims describe preferred embodiments of the invention.

According to an aspect of the invention, a subsea electronic system comprising a water tight enclosure adapted to enable an operation of the system under water and a heat generating electronic component arranged in the enclosure is provided, the electronic component generating heat in operation. The subsea electronic system further comprises a dielectric .liquid which at least partially fills the enclosure, the subsea electronic system being configured such that when the subsea electronic system is deployed under water in an operating state, the electronic component is at least partially submerged in the dielectric liquid. A heat sink is arranged on and thermally coupled to an outer side of a wall of the enclosure such that when the subsea electronic system is deployed under water in the operating state, the heat sink is in contact with water surrounding the enclosure, so as to enable a transfer of heat from the heat generating electronic component to the water surrounding the enclosure via the dielectric liquid, the heat sink and the wall.

The heat sink comprises a base which abuts the wall or is part of the wall of the enclosure and a plurality of heat dissipating elements extending from the base, the heat dissipating elements being at least one of fins or pins.

In an embodiment, the subsea electronic system can further comprise a heat sink arranged on and thermally coupled to an inner side of a wall of the enclosure such that when the subsea electronic system is deployed under water in the operating state, said further heat sink is in contact with said dielectric liquid.

When arranged inside the enclosure, the heat sink is in contact with the dielectric liquid and can thus take up heat produced by the electronic component and, due to the thermal coupling, transfer this heat to the wall of the enclosure. Similarly, when arranged outside the enclosure, the heat sink can take up heat, via the thermal coupling from the enclosure's wall and transfer it to the surrounding water which it is in contact with. The transfer of heat from the electronic component to the surrounding water is thus improved and accordingly, the electronic component is cooled more efficiently. It thus becomes possible to operate an electronic component at a lower operating temperature, thus making it less susceptible to overheating, which may lead to an enhanced reliability, reduced maintenance intervals and an extended lifetime of the component. Compared to conventional systems, it is also possible to house an electronic component which generates more heat in the same type of enclosure without a rise in operating temperature.

According to the invention, the enclosure is a pressure compensated enclosure which is filled with the dielectric liquid. The walls of such enclosure can be thinner, leading to a reduced thermal resistance and a better heat transfer to the outside of the enclosure. The electronic component may then be completely submerged in the dielectric liquiud.

Pressure compensated generally means that the pressure inside the enclosure is equalized to the pressure in the surroundings of the enclosure, wherein a small pressure difference can exist between inside and outside pressure. Depending on the deployment depth, such pressure difference is usually smaller than 10%, smaller than 1% or even smaller than 0.1% of the outside pressure. The inside of the enclosure can be kept at a small overpressure. Pressure compensation may for example occur by one or more pressure compensators which can comprises a flexible member (such as a membrane, a bladder or a bellow) that may be pretensioned, e.g. using a spring, a weight or the like, for generating a small overpressure.

In other embodiments, the enclosure can be a pressure resistant enclosure in which a pressure smaller than the outside pressure at deployment depth is maintained. For this purpose, the enclosure may be partially filled with a gas. The gas may comprise air or nitrogen (N₂), it may also comprise sulfur hexafluoride (SF6). The inside pressure is preferably close to one atmosphere. This way, electronic components that are not compatible with high operating pressures can be used in the enclosure and can benefit from the improved heat dissipation across the wall of the enclosure.

According to the invention, the subsea electronic system can be adapted to be operated a depth of water of at least 1000 m, preferably at least 2000 m. With such a configuration, the subsea electronic system can be deployed at most offshore drilling sites.

The electronic component may comprise power electronics. The power electronics may for example be part of a transformer, a rectifier, an inverter, switchgear, a variable speed drive (VSD) or the like. Such power electronics can produce large amounts of heat and can thus benefit from the improved heat dissipation provided by the heat sink.

The subsea electronic system can comprise a heat sink both on the inner side and the outer side of the wall of the enclosure. Both heat sinks can be arranged in an overlapping manner on the inner/outer sides of the wall. The contact surface with both the inner dielectric liquid and the surrounding water can thus be increased, which can further enhance the heat dissipation through the wall of the enclosure.

In an embodiment, the heat sink comprises a base which abuts the wall or is part of the wall of the enclosure and a plurality of heat dissipating elements extending from the base. The elements may be fins, pins or the like and may extend perpendicular to the base, or may fan out. This increases the contact area with the liquid (the inner dielectric liquid or the surrounding water) and thus improves the heat conduction across the wall. The heat sink may for example comprise a pin fin, a straight fin or a flared fin heat sink or a combination thereof.

The heat sink may be formed from a material having a thermal conductivity of at least 200 W/ (m•K). As an example, the heat sink may be formed from a metal, preferably from aluminium.

There are different possibilities of providing a heat sink arranged on the wall. In an embodiment, the heat sink is mechanically mounted to the wall by one or more mechanical fastening members, or is physically or chemically bonded to the wall of the enclosure, e.g. using an adhesive or the like. The heat sink can thus be mounted in a simple way.

The thermal coupling may then at least partially be provided by a direct mechanical contact between a back face of the heat sink and the wall of the enclosure or by the bonding material used for the physical or chemical bonding. The fastening member may for example press the heat sink against the wall, thus achieving a good thermal coupling.

When the heat sink is mounted to the wall of the enclosure, the thermal coupling may also at least partially be provided by a heat conducting material arranged in a split formed between the heat sink and the wall of the enclosure. Such heat conducting material may for example comprise the dielectric liquid in which the heat sink is at least partially submerged, a heat conducting paste, a thermal grease, a heat sink compound or the like. Heat transfer between heat sink and wall can thus be improved.

In another embodiment, the heat sink and the wall of the enclosure are integrally formed. The heat sink and the wall thus form a single piece, which may lead to improved heat conduction between the heat sink and the wall. Furthermore, heat sink and wall may be produced in a single production step.

In an embodiment, the enclosure and the heat generating electronic component are arranged and configured such that in operation of the subsea electronic system, a convection current is established in said dielectric liquid. The electronic component may for example be spaced and oriented relative to the heat sink and the wall of the enclosure in such a way that the convection current can be established. In operation, a flow is thus generated in the dielectric liquid. The flow can support the transfer of heat from the electronic component to the heat sink and to the wall of the enclosure.

Establishing the convection current further has the advantage that no additional mechanical or electrical components for generating a flow in the liquid need to be provided, thus simplifying the design of the system. Yet the provisioning of such components is certainly conceivable. In an embodiment, the subsea electronic system may further comprise a flow generating element disposed in the enclosure and adapted to actively generate a flow in the dielectric liquid for supporting the transportation of heat generated by the electronic component to the heat sink and the wall of the enclosure. The flow generating element may for example comprise a pumping mechanism, a rotor, a propeller, an impeller or the like. By actively driving the flow of the dielectric liquid, even higher heat dissipation can be achieved.

When the heat sink is disposed inside the enclosure, the subsea electronic system may further comprise a flow guiding member adapted to guide the flow of the dielectric liquid towards the heat sink. A metal or a plastic plate may be used as a flow guiding member. The flow guiding member can be arranged so as to gather warmed up dielectric liquid and feed it through the heat sink. This way, the heat exchange between dielectric liquid and heat sink may be further improved.

The heat sink can comprise a plurality of heat dissipating elements, and may be arranged such that the heat dissipating elements are aligned in a direction or extend in a direction that is substantially parallel to the direction of the flow of the dielectric liquid (i.e. the convection current or the actively generated flow) in proximity to the wall on which the heat sink is arranged. As the heat sink is oriented such that the heat dissipating elements are parallel to the direction of liquid flow, the flow resistance of the elements is kept small, leading to a higher flow velocity and thus a better heat transfer.

The dielectric liquid may be oil, such as transformer oil or silicon oil. Such types of dielectric liquid have good electrical insulating properties and remain stable even at high temperatures. Electrical breakdowns, which may occur due to electric sparking or arcing, may thus be prevented. A liquid dielectric further recovers its dielectric performance after sparking.

The features of the embodiments mentioned above and those yet to be explained below can be combined with each other unless noted to the contrary.

### Brief description of the drawings

The forgoing and other features and advantages of the invention will become further a parent from the following detailed description read in conjunction with the accompanying drawings. In the drawings, like reference numerals refer to like elements.
Figure 1 shows a schematic drawing of a subsea electronic system according to an embodiment.
Figure 2 schematically illustrates the heat sink of the subsea electronic system of Fig. 1 in more detail.
Figure 3 shows a schematic drawing of a section of the subsea electronic system of Fig. 1 in which convection currents are illustrated.
Figure 4 is a schematic drawing of a subsea electronic system according to another embodiment of the invention.

In the following, embodiments of the present invention will be described in detail with reference to the accompanying drawings. It is to be understood that the following description of the embodiments is given only for the purpose of illustration and is not to be taken in a limiting sense.

It should be noted that the drawings are to be regarded as being schematic representations only, and elements in the drawings are not necessary to scale with each other. Rather, the representation of the various elements is chosen such that their function and general purpose becomes apparent to a person skilled in the art.

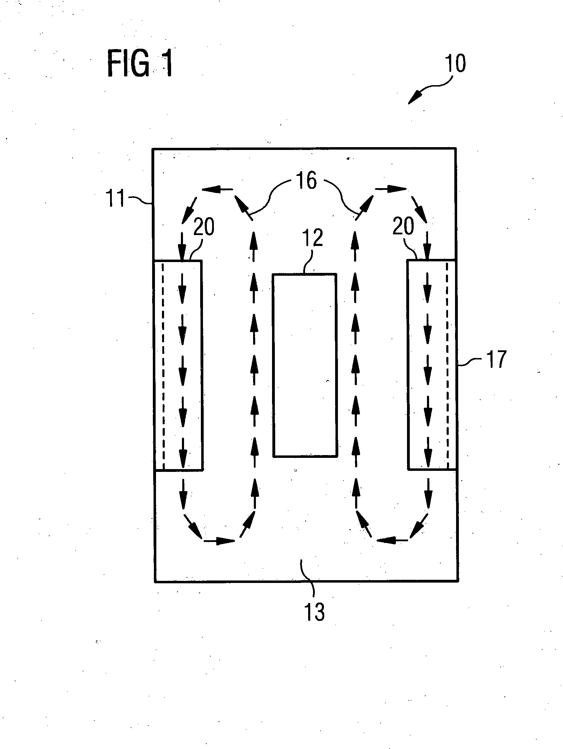

Figure 1 is a sectional side view illustrating a subsea electronic system 10 which comprises a pressure compensated enclosure 11 in which a heat generating electronic component 12 is disposed. The enclosure 11 is water tight, so that when the system 10 is deployed under water, no water can enter the enclosure.

Enclosure 11 is a pressure compensated enclosure, i.e. an enclosure that equalizes its inner pressure with the pressure of the medium surrounding the enclosure, e.g. with the surrounding water pressure. This can be achieved by completely filling the free volume inside the enclosure with a dielectric liquid 13 and providing one or more pressure compensators (not shown) which transmit the outside pressure to the inside of the enclosure. For pressure transmission, the compensator can comprise a flexible element, such as a bellow, a membrane, a bladder or the like. Outside and inside pressure are thus approximately equal. Arrangements for slightly increasing the inside pressure can be provided. Such arrangements may comprise a spring or a weight which apply a force to the flexible member for creating an overpressure inside the enclosure. This prevents the entering of water. As the pressure differences are relatively small, the enclosure 11 can be provided with relatively thin walls (compared to a pressure resistant enclosure).

Enclosure 11 protects the electronic component 12 from the sea water. The pressure compensation allows for a deployment of the system 10 at great water depths, e.g. at depths of more than 1000m or even more than 2000m. It can thus house electronic components of a subsea oil/gas production facility, e.g. a subsea power grid. The electronic component 12 is accordingly adapted to operate at such high ambient pressures.

In other embodiments, enclosure 11 can be a pressure resistant enclosure. The walls of the enclosure 11 may then be configured so as to maintain a predefined pressure inside the enclosure when it is submerged under water, e.g. an inside pressure of about one atmosphere. Enclosure 11 can be configured to maintain the inside pressure up to a deployment depth of at least 1000m, preferably at least 2000m. Such configuration enables the use of electronic components which need to be maintained at a pressure close to one atmosphere, and which may become inoperable or may be destroyed at higher pressures. The enclosure 11 may then only partially be filled with the dielectric liquid 13, and partially be filled with a gas or a gas mixture, such as air, nitrogen or SF₆. The small volume of gas can compensate small deformations (and thus volume changes) of the enclosure without causing an excessive increase of the inside pressure.

The size of the enclosure can be adapted to the size of the electronic component it is supposed to house. The enclosure may have a volume of more than 1000cm³, or for larger components of more than 10000 cm³ or even more than 100000 cm³.

The dielectric liquid 13 may be oil, such as transformer oil or silicon oil, and is furthermore provided for cooling the electronic component 12. The dielectric liquid 13 further provides good electric insulation.

The electronic component 12 may comprise power electronics. In particular, it may comprise electronic components for the control and conversion of electric power. Examples are components of transformers, rectifiers, inverters, switchboards, variable frequency drives and the like. It may comprise electronic elements in form of a thyristor (e.g. force commutated thyristor), a power BJT (bipolar junction transistor), a power MOSFET (metal-oxide-semiconductor field-effect transistor), a GTO (gate turn-off thyristor), an IGBT (insulated-gate bipolar transistor) or the like. It may certainly also comprise other types of electric or electronic elements, such as resistors, capacitors, and any types of circuit elements and integrated circuits. These elements may be provided on a printed or another type of circuit board.

Due to heat losses in the electronic elements, the electronic component 12 generates heat in operation. The electronic component 12 is at least partially submerged in the dielectric liquid 13, i.e. it is in direct contact with the liquid, thereby ensuring a good transfer of heat from the electronic component 12 to the dielectric liquid 13. In particular, the electronic component 12 can be submerged in the liquid 13 in such a way that all the electronic elements that produce excess heat and require cooling are submerged in the liquid. In the example of figure 1, the electronic component 12 is completely submerged, so that all electronic elements thereon are cooled. The direct contact between the dielectric liquid and the electronic elements provides a good thermal conductivity and thus an efficient cooling. As the dielectric liquid is insulating, the functionality of the electronic component 12 is not compromised by submerging it in the liquid. If an electronic element is incompatible with an operation in dielectric liquid, it may be provided with a protective housing, for example by molding. Even such types of elements can thus be cooled by the dielectric liquid.

The dielectric liquid 13 generally has a much higher thermal conductivity and heat capacity than a gas or gas mixture. Heat produce by electrical component 12 is thus efficiently taken up and transported by the dielectric liquid 13. The dielectric liquid 13 transfers the heat which it has taken up to the heats sinks 20 and the walls of the container 11 which it contacts.

In particular when implementing power electronics, component 12 produces a large amount of heat which can not be dissipated by wall 17, leading to a substantial rise in temperature inside the enclosure 11. In the embodiment of Fig. 1, a heat sink 20 is arranged on the inner side of the wall 17. The heat sink is thermally coupled to the wall 17, i.e. the arrangement is such that heat is efficiently conducted between heat sink 20 and wall 17 (and via versa if the heat sink is mounted to the outer side of wall 17).

Heat sink 20 provides a large contact area with the dielectric liquid 13. The heat sink thus efficiently takes up heat from the dielectric liquid and transfers it to wall 17, from where it is dissipated into the surrounding water.

For enhancing the heat dissipation into the surrounding water, an additional heat sink can be provided on the opposite, outer side of wall 17. Further heat sinks 20 can be provided on walls of the enclosure, as illustrated in Fig. 1.

Heat transfer can occur by thermal conduction of the generated heat via the dielectric liquid to heat sink 20 and the wall 17 of the enclosure 11, and it can be supported by convection. In particular, the subsea electronic system can be configured in such a way that a convection current 16 (also called advection) forms in the dielectric liquid 13. Such convection currents 16 can form naturally due to the differences in density of heated and cooled dielectric liquid 13. Liquid warmed up by the electronic component 12 is generally less dense and will thus rise, leading to the formation of the convection current.

In the example of Fig.1, the electronic component 12 is positioned close to the center of the enclosure 11 and at a predefined distance to the heat sinks 20 and the walls of the enclosure. Dielectric liquid in contact with the electronic component 12 takes up heat generated by the component and rises, whereas dielectric liquid in contact with the heat sinks 20 and the walls is cooled and drops. The spacing between the heat sinks, the walls and electronic component 12 is chosen such that the convection processes generates the fluid flow 16 (convection current). Other configurations for generating a convectional fluid flow or arrangements of component 12 relative to the enclosure 11 are certainly conceivable.

The warmed up dielectric liquid transports the absorbed heat to heat sink 20, which takes up the heat and transfers it to wall 17, from where it is dissipated to the outside of the enclosure 11. The outer side of wall 17 is in contact with the surrounding water, to which the heat is transferred. The overall process does achieve effective heat dissipation.

By means of the thermal conduction and convection, the dielectric liquid 13 in combination with the heat sink 20 very effectively remove heat from the electronic component 12. The subsea electronic system 10 thereby provides an effective cooling of the electronic component 12 and ensures that the operating temperature of the electronic component maintains an acceptable level even for high heat losses. Electronic component 12 can thus be operated at low temperatures, which generally increases the reliability of the component. Operation at higher temperatures further often decreases the lifetime of electronic components, so that by providing the above mentioned effective cooling, the lifetime can be increased and maintenance requirements can be reduced.

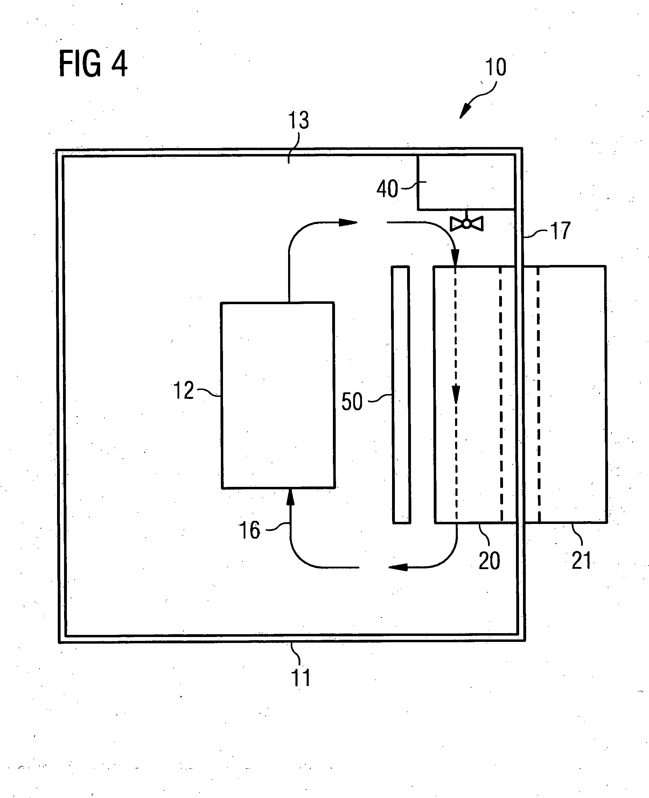

It should be clear that the subsea electronic system 10 may comprise further components that are not illustrated in figure 1, such as the components illustrated with respect to the subsequent figure 4. Other components may for example comprise a mount or a support structure by means of which the electronic component 12 is supported on a wall of the enclosure 11, or other elements commonly used in such systems. Enclosure 11 may for example be a subsea canister. It should further be clear that the electronic component 12 does not need to comprise a circuit board, chips, integrated circuits or any of above mentioned electronic elements, but may comprise very simple electronics requiring cooling, such the above-mentioned power electronics.

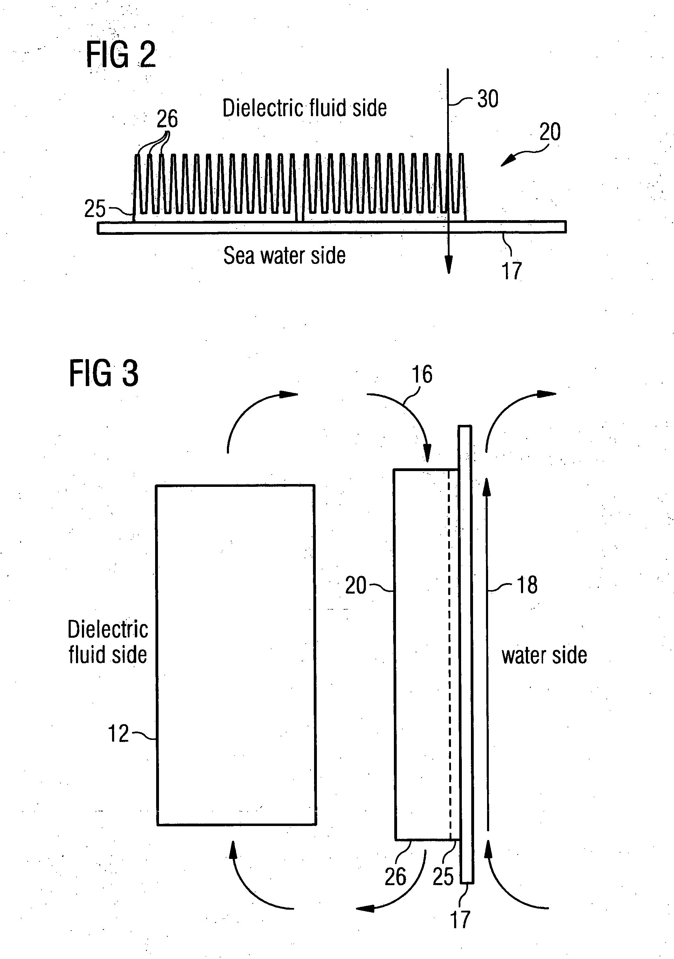

Figs. 2 and 3 illustrate the heat sink 20 of Fig. 1 in more detail. Fig. 2 is a top view of the heat sink 20. Arrow 30 illustrates the direction of the heat flow from the dielectric fluid side (inner side) to the water side (outer side) across wall 17 of the enclosure 11. In the example of Fig. 2, the heat sink 20 comprises a base 25 from which a plurality of heat dissipating elements 26 extend into the dielectric fluid 13. Elements 26 may be fins, pins or the like. In Fig. 1, only one element 26 is visible as the elements 26 extend in a plane parallel to the image plane. The heat dissipating elements 26 increase the contact area with the dielectric liquid substantially. Thereby, the heat transfer from the dielectric liquid 13 to heat sink 20 and thus to wall 17 is enhanced.

Besides this straight fin type heat sink illustrated in Fig. 2, heat sink 20 may be provided in other configurations, for example as a pin or flare fin heat sink. Fig. 2 illustrates a heat sink 20 which comprises two separate sections. It should be clear that the heat sink can comprise only one section may be made up of more than two separate sections.

Heat sink 20 is thermally coupled to wall 17. In particular, the heat sink is adapted and arranged on wall 17 in such a way that a good heat transfer between sink 20 and wall 17 is achieved. The heat sink can be mounted mechanically to wall 17, e.g. by using bolts, clamps, rivets or the like. The mechanical mount can apply pressure to the heat sink, so that a firm mechanical contact is established leading to good thermal conductivity. The heat sink may also be bonded to the wall by means of an adhesive.

In configurations in which a split exists between the heat sink and the wall, the split may be filled with the dielectric liquid or another material having a high thermal conductivity, such as a heat conductive paste, a thermal grease or the like in order to improve the heat transfer.

It is also conceivable to integrally form the heat sink 20 and the wall 17. This way, both elements can be produced in a single step and a good thermal conductivity between both elements is ensured.

The heat sink may be formed of a metal such as aluminum or any other suitable material. Due to its structure, the heat sink provides a large contact area with the dielectric fluid, and thus effectively increases the contact area of the dielectric fluid with the wall 17.

Fig. 3 shows the section of wall 17 towards which the heat sink 20 is mounted in more detail. The fins of the heat sink 20 are aligned in a way so that the fluid flow of the convection current 16 is parallel to the elongation of the fins 26. This way, the fins of the heat sink apply a small flow resistance to the convection current 16. In Fig. 3, the reference symbol 18 illustrates a flow of water along the outer side of wall 17 of the enclosure 11. The water takes up heat from wall 17. The warmed up water rises, thereby creating an outer convection current as illustrated (reference numeral 18). Effective cooling is thus achieved. For further improving the heat dissipation, it is conceivable to place another heat sink on the outer side of wall 17, i.e. the water side.

Such a configuration is illustrated in Fig. 4. Fig. 4 shows modifications to the subsea electronic system 10 illustrated in Fig. 1; the above explanations are thus equally applicable to the subsea electronic system 10 illustrated in Fig. 4.

Wall 17 of the subsea electronic system 10 is now provided with an inner heat sink 20 and an outer heat sink 21. The outer heat sink 21 can be configured as outlined above with respect to Fig. 2.

The subsea electronic system 10 illustrated in Fig. 4 is further provided with a flow generating element. The flow generating element 40 is has the form of a propeller coupled to a motor, the propeller generating a flow in the dielectric liquid when rotated. In the example of figure 4, the flow generating element is positioned such that the generated flow is forced through the heat sink 20. This enhances the efficiency of the heat sink and improves the heat exchange. Flow generating element 40 may also be provided in other positions, for example so as to generate a flow past the electronic component 12.

Other implementations of element 40 include an impeller, different types of pump arrangements or any other configuration conceivable for generating a flow in the dielectric liquid.

The subsea electronic system 10 of Fig. 4 further comprises a flow guiding member 50. It ensures that the flow of dielectric fluid passes along the heat sink 20 and does not leave the heat sink prematurely. It is further used to guide the flow towards the heat sink. In other implementations, a flow guiding member may be provided for guiding a flow of liquid towards the electronic component 12. The flow guiding member 50 can certainly be used without the flow generating element 40, e.g. for directing a convection flow into the desired direction.

The flow guiding member 50 is used to control the flow in the dielectric liquid. It can for example be implemented as one or more plates, which can be made out of steel, plastic or other suitable materials. A flow guiding member may also be placed on top of heat sink 20 in order to gather the warmed up dielectric fluid and feed it through the heat sink. This is possible both for configurations having an actively driven fluid flow and for configurations using only the convection current.

The skilled person will appreciate that the additional features of the subsea electronic system 10 illustrated in Fig. 4 are optional and can be used in other combinations as the ones indicated. The configuration of system 10 can be adapted to the particular cooling requirements.

The subsea electronic system of the present invention can be deployed at great water depths while still maintaining a watertight seal and effectively cooling the electronic component. The heat sink enhances the heat exchange between the internal dielectric fluid and the external water, thus providing an effective dissipation of large amounts of heat.

## Claims

1. A subsea electronic system (10), comprising:
- a water tight enclosure (11) adapted to enable an operation of the system (10) under water;
- a heat generating electronic component (12) arranged in the enclosure (11), the electronic component (12) generating heat in operation;
- a dielectric liquid (13) which at least partially fills said enclosure (11), the subsea electronic system (10) being configured such that when the subsea electronic system (10) is deployed under water in an operating state, the electronic component (12) is at least partially submerged in the dielectric liquid (13), and
- a heat sink (21) arranged on and thermally coupled to an outer side of a wall (17) of the enclosure (11) such that when the subsea electronic system (10) is deployed under water in the operating state, the heat sink (21) is in contact with water surrounding the enclosure, so as to enable a transfer of heat from the heat generating electronic component (12) to the water surrounding the enclosure (11) via the dielectric liquid (13), the heat sink (21) and the wall (17),
**characterized in that**
the enclosure (11) is a pressure compensated enclosure, the enclosure being filled with said dielectric liquid (13), the subsea electronic system (10) being adapted to be operated at a depth of water of at least 1000 m, preferably at least 2000 m, and that
the heat sink comprises a base (25) which abuts the wall (17) or is part of the wall (17) of the enclosure (11) and a plurality of heat dissipating elements (26) extending from the base (25), the heat dissipating elements (26) being at least one of fins or pins.

2. The subsea electronic system according to any of the preceding claims, wherein the electronic component (12) comprises power electronics.

3. The subsea electronic system according to any of the preceding claims, further comprising a heat sink (20) arranged on and thermally coupled to an inner side of a wall (17) of the enclosure (11) such that when the subsea electronic system (10) is deployed under water in the operating state, said further heat sink (20) is in contact with said dielectric liquid (13).

4. The subsea electronic system according to any of the preceding claims, wherein a heat sink (20, 21) is provided on both the inner side and the outer side of the wall (17) of the enclosure (11).

5. The subsea electronic system according to any of the preceding claims, wherein the heat sink (20, 21) comprises a pin fin, a straight fin or a flared fin heat sink or a combination thereof.

6. The subsea electronic system according to any of the preceding claims, wherein the heat sink (20, 21) is mechanically mounted to the wall (17) by one or more mechanical fastening members, or is physically or chemically bonded to the wall of the enclosure (11).

7. The subsea electronic system according to claim 6, wherein the thermal coupling is at least partially provided by a direct mechanical contact between a back face of the heat sink (20, 21) and the wall (17) of the enclosure (11) or by the bonding material used for the physical or chemical bonding.

8. The subsea electronic system according to any of the preceding claims, wherein the heat sink is mounted to the wall (17) of the enclosure (11), the thermal coupling being at least partially provided by a heat conducting material arranged in a split formed between the heat sink (21, 22) and the wall (17) of the enclosure, the heat conducting material preferably comprising at least one of the dielectric liquid, a heat conducting paste, a thermal grease, and a heat sink compound.

9. The subsea electronic system according to any of claims 1-5, wherein the heat sink (20, 21) and the wall (17) of the enclosure (11) are formed integrally.

10. The subsea electronic system according to any of the preceding claims, wherein the enclosure (11) and the heat generating electronic component (12) are arranged and configured such that in operation of the system (10), a convection current (16) is established in said dielectric liquid (13).

11. The subsea electronic system according to any of the preceding claims, wherein the system further comprises a flow generating element (40) disposed in the enclosure (11) and adapted to actively generate a flow in the dielectric liquid (13).

12. The subsea electronic system according to claim 10 or 11, wherein the heat sink is disposed inside the enclosure, the system (10) further comprising a flow guiding member (50) adapted to guide the flow of the dielectric liquid (13) towards the heat sink (20).

13. The subsea electronic system according to any of claims 10-12, wherein the heat sink (20) is disposed inside the enclosure (11), the heat sink (20) comprising a plurality of heat dissipating elements (26), the heat sink (20) being arranged such that the heat dissipating elements (26) are aligned in a direction or extend in a direction that is substantially parallel to the direction of the flow (16) of the dielectric liquid (13) in proximity to said wall (17).

## Patentansprüche

1. Unterwasserelektroniksystem (10), welches umfasst:
- eine wasserdichte Umhüllung (11), die dazu eingerichtet ist, einen Betrieb des Systems (10) unter Wasser zu ermöglichen;
- ein Wärme erzeugendes elektronisches Bauteil (12), das in der Umhüllung (11) angeordnet ist, wobei das elektronische Bauteil (12) im Betrieb Wärme erzeugt;
- eine dielektrische Flüssigkeit (13), welche die Umhüllung (11) wenigstens teilweise füllt, wobei das Unterwasserelektroniksystem (10) derart eingerichtet ist, dass, wenn das Unterwasserelektroniksystem (10) unter Wasser in einem Betriebszustand eingesetzt ist, das elektronische Bauteil (12) wenigstens teilweise in die dielektrische Flüssigkeit (13) eingetaucht ist; und
- eine Wärmesenke (21), die auf einer Außenseite einer Wand (17) der Umhüllung (11) angeordnet und mit dieser thermisch gekoppelt ist, derart, dass, wenn das Unterwasserelektroniksystem (10) unter Wasser in dem Betriebszustand eingesetzt ist, die Wärmesenke (21) sich in Kontakt mit Wasser befindet, das die Umhüllung umgibt, um eine Übertragung von Wärme von dem Wärme erzeugenden elektronischen Bauteil (12) auf das die Umhüllung (11) umgebende Wasser über die dielektrische Flüssigkeit (13), die Wärmesenke (21) und die Wand (17) zu ermöglichen,
**dadurch gekennzeichnet, dass**
die Umhüllung (11) eine druckausgeglichene Umhüllung ist, wobei die Umhüllung mit der dielektrischen Flüssigkeit (13) gefüllt ist, wobei das Unterwasserelektroniksystem (10) dazu eingerichtet ist, in einer Wassertiefe von wenigstens 1000 m, vorzugsweise von wenigstens 2000 m, betrieben zu werden, und dass
die Wärmesenke ein Unterteil (25), welches an der Wand (17) anliegt oder Teil der Wand (17) der Umhüllung (11) ist, und mehrere Wärme ableitende Elemente (26), die sich von dem Unterteil (25) aus erstrecken, umfasst, wobei die Wärme ableitenden Elemente (26) Rippen und/oder Stifte sind.

2. Unterwasserelektroniksystem nach einem der vorhergehenden Ansprüche, wobei das elektronische Bauteil (12) Leistungselektronik umfasst.

3. Unterwasserelektroniksystem nach einem der vorhergehenden Ansprüche, welches ferner eine Wärmesenke (20) umfasst, die auf einer Innenseite einer Wand (17) der Umhüllung (11) angeordnet und mit dieser thermisch gekoppelt ist, derart, dass, wenn das Unterwasserelektroniksystem (10) unter Wasser in dem Betriebszustand eingesetzt ist, die weitere Wärmesenke (20) sich in Kontakt mit der dielektrischen Flüssigkeit (13) befindet.

4. Unterwasserelektroniksystem nach einem der vorhergehenden Ansprüche, wobei eine Wärmesenke (20, 21) sowohl auf der Innenseite als auch auf der Außenseite der Wand (17) der Umhüllung (11) vorgesehen ist.

5. Unterwasserelektroniksystem nach einem der vorhergehenden Ansprüche, wobei die Wärmesenke (20, 21) eine Stift-Rippen-Wärmesenke, eine Wärmesenke mit geraden Rippen oder eine Wärmesenke mit aufgeweiteten Rippen oder eine Kombination davon umfasst.

6. Unterwasserelektroniksystem nach einem der vorhergehenden Ansprüche, wobei die Wärmesenke (20, 21) durch ein oder mehrere mechanische Befestigungselemente mechanisch an der Wand (17) angebracht ist oder physikalisch oder chemisch an die Wand der Umhüllung (11) gebunden ist.

7. Unterwasserelektroniksystem nach Anspruch 6, wobei die thermische Kopplung wenigstens teilweise durch einen direkten mechanischen Kontakt zwischen einer Rückseitenfläche der Wärmesenke (20, 21) und der Wand (17) der Umhüllung (11) oder durch das Bindungsmaterial, das für die physikalische oder chemische Bindung verwendet wird, gewährleistet wird.

8. Unterwasserelektroniksystem nach einem der vorhergehenden Ansprüche, wobei die Wärmesenke an der Wand (17) der Umhüllung (11) angebracht ist, wobei die Wärmekopplung wenigstens teilweise durch ein wärmeleitendes Material gewährleistet wird, das in einem Spalt angeordnet ist, der zwischen der Wärmesenke (21, 22) und der Wand (17) der Umhüllung ausgebildet ist, wobei das wärmeleitendes Material vorzugsweise die dielektrische Flüssigkeit, eine Wärmeleitpaste, ein thermisches Fett und/oder eine Kühlkörperverbindung umfasst.

9. Unterwasserelektroniksystem nach einem der Ansprüche 1-5, wobei die Wärmesenke (20, 21) und die Wand (17) der Umhüllung (11) einstückig ausgebildet sind.

10. Unterwasserelektroniksystem nach einem der vorhergehenden Ansprüche, wobei die Umhüllung (11) und das Wärme erzeugende elektronische Bauteil (12) derart angeordnet und ausgebildet sind, dass im Betrieb des Systems (10) ein Konvektionsstrom (16) in der dielektrischen Flüssigkeit (13) bewirkt wird.

11. Unterwasserelektroniksystem nach einem der vorhergehenden Ansprüche, wobei das System ferner ein strömungserzeugendes Element (40) umfasst, das in der Umhüllung (11) angeordnet ist und dazu eingerichtet ist, aktiv eine Strömung in der dielektrischen Flüssigkeit (13) zu erzeugen.

12. Unterwasserelektroniksystem nach Anspruch 10 oder 11, wobei die Wärmesenke innerhalb der Umhüllung angeordnet ist, wobei das System (10) ferner ein strömungsleitendes Element (50) umfasst, das dazu eingerichtet ist, die Strömung der dielektrischen Flüssigkeit (13) in Richtung der Wärmesenke (20) zu leiten.

13. Unterwasserelektroniksystem nach einem der Ansprüche 10-12, wobei die Wärmesenke (20) innerhalb der Umhüllung (11) angeordnet ist, wobei die Wärmesenke (20) mehrere Wärme ableitende Elemente (26) umfasst, wobei die Wärmesenke (20) derart angeordnet ist, dass die Wärme ableitenden Elemente (26) in einer Richtung ausgerichtet sind oder sich in einer Richtung erstrecken, welche im Wesentlichen parallel zur Richtung der Strömung (16) der dielektrischen Flüssigkeit (13) in der Nähe der Wand (17) ist.

## Revendications

1. Un système électronique sous-marin (10), comprenant :
- une enceinte étanche (11) adaptée de façon à permettre une exploitation du système (10) sous l'eau,
- un composant électronique calogène (12) agencé dans l'enceinte (11), le composant électronique (12) générant de la chaleur en fonctionnement,
- un liquide diélectrique (13) qui remplit au moins partiellement ladite enceinte (11), le système électronique sous-marin (10) étant configuré de sorte que, lorsque le système électronique sous-marin (10) est déployé sous l'eau dans un état opérationnel, le composant électronique (12) soit au moins partiellement submergé dans le liquide diélectrique (13), et
- un dissipateur thermique (21) agencé sur et thermiquement couplé à un côté extérieur d'une paroi (17) de l'enceinte (11) de sorte que, lorsque le système électronique sous-marin (10) est déployé sous l'eau dans l'état opérationnel, le dissipateur thermique (21) soit en contact avec l'eau entourant l'enceinte, de façon à permettre un transfert de chaleur du composant électronique calogène (12) vers l'eau entourant l'enceinte (11) au travers du liquide diélectrique (13), du dissipateur thermique (21) et de la paroi (17),
**caractérisé en ce que**
l'enceinte (11) est une enceinte à compensation de pression, l'enceinte étant remplie avec ledit liquide diélectrique (13), le système électronique sous-marin (10) étant adapté de façon à être exploité à une profondeur d'eau d'au moins 1000 m, de préférence d'au moins 2000 m, et **en ce que**
le dissipateur thermique comprend une base (25) qui vient en butée contre la paroi (17) ou fait partie de la paroi (17) de l'enceinte (11) et une pluralité d'éléments de dissipation thermique (26) s'étendant à partir de la base (25), les éléments de dissipation thermique (26) étant au moins un élément parmi des ailettes ou des broches.

2. Le système électronique sous-marin selon l'une quelconque des revendications précédentes, dans lequel le composant électronique (12) comprend une électronique de puissance.

3. Le système électronique sous-marin selon l'une quelconque des revendications précédentes, comprenant en outre un dissipateur thermique (20) agencé sur et thermiquement couplé à un côté intérieur d'une paroi (17) de l'enceinte (11) de sorte que, lorsque le système électronique sous-marin (10) est déployé sous l'eau dans l'état opérationnel, ledit autre dissipateur thermique (20) soit en contact avec ledit liquide diélectrique (13).

4. Le système électronique sous-marin selon l'une quelconque des revendications précédentes, dans lequel un dissipateur thermique (20, 21) est installé sur à la fois le côté intérieur et le côté extérieur de la paroi (17) de l'enceinte (11).

5. Le système électronique sous-marin selon l'une quelconque des revendications précédentes, dans lequel le dissipateur thermique (20, 21) comprend un dissipateur thermique à ailettes à broche, à ailettes rectilignes ou à ailettes évasées, ou une combinaison de ceux-ci.

6. Le système électronique sous-marin selon l'une quelconque des revendications précédentes, dans lequel le dissipateur thermique (20, 21) est monté mécaniquement sur la paroi (17) par un ou plusieurs éléments de fixation mécaniques, ou est physiquement ou chimiquement relié à la paroi de l'enceinte (11).

7. Le système électronique sous-marin selon la revendication 6, dans lequel le couplage thermique est fourni au moins partiellement par un contact mécanique direct entre une face arrière du dissipateur thermique (20, 21) et la paroi (17) de l'enceinte (11) ou par le matériau de liaison utilisé pour la liaison physique ou chimique.

8. Le système électronique sous-marin selon l'une quelconque des revendications précédentes, dans lequel le dissipateur thermique est monté sur la paroi (17) de l'enceinte (11), le couplage thermique étant au moins partiellement fourni par un matériau thermoconducteur agencé dans une fente formée entre le dissipateur thermique (21, 22) et la paroi (17) de l'enceinte, le matériau thermoconducteur contenant de préférence au moins un produit parmi le liquide diélectrique, une pâte thermoconductrice, une graisse thermoconductrice et un composé de dissipateur thermique.

9. Le système électronique sous-marin selon l'une quelconque des revendications 1 à 5, dans lequel le dissipateur thermique (20, 21) et la paroi (17) de l'enceinte (11) sont formés d'un seul tenant.

10. Le système électronique sous-marin selon l'une quelconque des revendications précédentes, dans lequel l'enceinte (11) et le composant électronique calogène (12) sont agencés et configurés de sorte que, en exploitation du système (10), un courant de convection (16) soit établi dans ledit liquide diélectrique (13).

11. Le système électronique sous-marin selon l'une quelconque des revendications précédentes, dans lequel le système comprend en outre un élément de génération d'écoulement (40) disposé dans l'enceinte (11) et adapté de façon à générer de manière active un écoulement dans le liquide diélectrique (13).

12. Le système électronique sous-marin selon la revendication 10 ou 11, dans lequel le dissipateur thermique est disposé à l'intérieur de l'enceinte, le système (10) comprenant en outre un élément de guidage d'écoulement (50) adapté de façon à guider l'écoulement du liquide diélectrique (13) vers le dissipateur thermique (20).

13. Le système électronique sous-marin selon l'une quelconque des revendications 10 à 12, dans lequel le dissipateur thermique (20) est disposé à l'intérieur de l'enceinte (11), le dissipateur thermique (20) comprenant une pluralité d'éléments de dissipation thermique (26), le dissipateur thermique (20) étant agencé de sorte que les éléments de dissipation thermique (26) soient alignés dans une direction ou s'étendent dans une direction qui est sensiblement parallèle à la direction de l'écoulement (16) du liquide diélectrique (13) à proximité de ladite paroi (17).
